# EUROPEAN PATENT SPECIFICATION

(11) **EP 3 012 294 B1**
(45) Date of publication and mention of the grant of the patent: **16.09.2020**
(21) Application number: 14814473.6
(22) Date of filing: 16.06.2014
(51) Int. Cl.: C08L 61/14, B32B 15/092, C08G 59/40, C08J 5/24, C08K 3/00, C08K 5/16, C08L 63/00, H05K 1/03, H01B 3/36

(54) **RESIN COMPOSITION, PREPREG, RESIN SHEET AND METAL FOIL-CLAD LAMINATE**
HARZZUSAMMENSETZUNG, PREPREG UND METALLFOLIENBESCHICHTETES LAMINAT
COMPOSITION DE RÉSINE, PRÉ-IMPRÉGNÉ, FEUILLE DE RÉSINE ET STRATIFIÉ RECOUVERT D'UNE FEUILLE MÉTALLIQUE

(30) Priority: 18.06.2013 JP 2013127440; 25.12.2013 JP 2013266949
(43) Date of publication of application: 27.04.2016
(73) Proprietor: Mitsubishi Gas Chemical Company, Inc., Tokyo 100-8324 (JP)
(72) Inventor: ARII, Kenji, Kurashiki-shi Okayama 712-8525 (JP); KOBAYASHI, Takashi, Tokyo 125-8601 (JP); SOGAME, Masanobu, Tokyo 125-8601 (JP); MABUCHI, Yoshinori, Tokyo 125-8601 (JP); MISHIMA, Hiroyuki, Tokyo 100-8324 (JP)
(74) Representative: Hoffmann Eitle
(86) International application number: PCT/JP2014/065939
(87) International publication number: WO 2014/203866

(56) References cited:
- WO-A1-2009/072465
- WO-A1-2012/132923
- WO-A1-2013/069479
- WO-A1-2013/084819
- WO-A1-2013/115290
- WO-A1-2013/129313
- JP-A- 2005 097 524
- JP-A- 2011 046 837
- DATABASE WPI Week 201109 Thomson Scientific, London, GB; AN 2011-A58311 XP002765539, & JP 2011 006593 A (DAINIPPON INK & CHEM INC) 13 January 2011 (2011-01-13)

## Description

### Technical Field

The present invention relates to a resin composition, a prepreg, and a resin sheet, a metal foil-clad laminate, and the like using the resin composition or the prepreg.

### Background Art

In recent years, higher integration and miniaturization of semiconductors widely used in electronic equipment, communication instruments, personal computers, and the like have accelerated increasingly. With this, various characteristics required of laminates for semiconductor packages used in printed wiring boards have become increasingly strict. Examples of the required characteristics include characteristics such as low water absorbency, moisture absorption and heat resistance properties, flame retardancy, a low dielectric constant, a low dielectric loss tangent, a low thermal expansion coefficient, heat resistance, and chemical resistance. Laminates for semiconductor packages have not always satisfied these required characteristics so far, however.

Conventionally, as resins for printed wiring boards having excellent heat resistance and electrical characteristics, cyanate ester compounds are known. For example, a resin composition using a bisphenol A-based cyanate ester compound and another thermosetting resin and the like is widely used for printed wiring board materials and the like. The bisphenol A-based cyanate ester compound has characteristics excellent in electrical characteristics, mechanical characteristics, chemical resistance, and the like but may be insufficient in low water absorbency, moisture absorption and heat resistance properties, and flame retardancy. Therefore, for the purpose of further improving characteristics, various cyanate ester compounds having different structures are studied.

As a resin having a different structure from the bisphenol A-based cyanate ester compound, a novolac-based cyanate ester compound is often used (for example, see Patent Document 1). However, there are problems such as the novolac-based cyanate ester compound being likely to be insufficiently cured, and the water absorption rate of the obtained cured product being high and the moisture absorption and heat resistance properties decreasing. As a method for improving these problems, the prepolymerization of a novolac-based cyanate ester compound and a bisphenol A-based cyanate ester compound is proposed (for example, see Patent Document 2).

In addition, as a method for improving flame retardancy, a halogen-based compound being contained in a resin composition by using a fluorinated cyanate ester compound or mixing or prepolymerizing a cyanate ester compound and a halogen-based compound is proposed (for example, see Patent Documents 3 and 4). Further cyanate-based resin compositions and uses thereof are also disclosed in Patent Documents 5 to 7. Patent Document 8 discloses resin compositions based on a naphthol-modified dimethylnaphthalene formaldehyde resin.

### List of Prior Art Documents

### Patent Document

Patent Document 1: Japanese Patent Laid-Open No. 11-124433
Patent Document 2: Japanese Patent Laid-Open No. 2000-191776
Patent Document 3: Japanese Patent No. 3081996
Patent Document 4: Japanese Patent Laid-Open No. 6-271669
Patent Document 5: Japanese Patent Laid-Open No. 2011-006593
Patent Document 6: WO 2013/069479 A1
Patent Document 7: WO 2013/084819 A1
Patent Document 8: WO 2012/132923 A1

### Summary of Invention

### Problems to be Solved by Invention

However, for the cyanate ester compounds described in Patent Document 2, the curability is improved by prepolymerization, but characteristics improvements in low water absorbency and moisture absorption and heat resistance properties are still insufficient, and therefore further improvements in low water absorbency and moisture absorption and heat resistance properties are required.

In addition, the resin compositions described in Patent Documents 3 and 4 use a halogen-based compound in order to improve flame retardancy, and therefore a harmful substance such as dioxin may be generated during combustion. Therefore, it is required to improve the flame retardancy of the resin composition without comprising a halogen-based compound.

It is an object of the present invention to provide a resin composition that can realize a printed wiring board that not only has low water absorbency but also has excellent moisture absorption and heat resistance properties and flame retardancy. In addition, it is an object of the present invention to provide a prepreg and a single-layer or laminated sheet using the resin composition, and a metal foil-clad laminate, a printed wiring board, and the like using the prepreg.

### Means for Solving Problems

The present inventors have diligently studied the above problems and, as a result, found that by using a resin composition containing a cyanate ester compound obtained by cyanating a modified naphthalene formaldehyde resin, low water absorbency can be provided, and excellent moisture absorption and heat resistance properties and flame retardancy can be realized, arriving at the present invention. Specifically, the present invention is as follows.
[1] A resin composition comprising:
   a cyanate ester compound (A) obtained by cyanating a modified naphthalene formaldehyde resin; and
   an epoxy resin (B),
   wherein the cyanate ester compound (A) has a structure represented by the following general formula (1) : 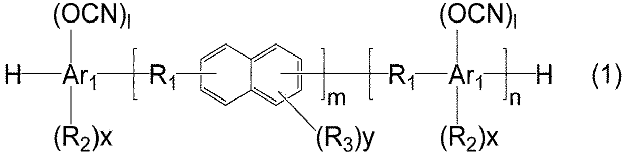 wherein Ar₁ represents an aromatic ring, R₁ each independently represents a methylene group, a methyleneoxy group, a methyleneoxymethylene group, an oxymethylene group, or a combination thereof, resulting from linking the same; R₂ represents a monovalent substituent and each independently represents a hydrogen atom, an alkyl group, or an aryl group, R₃ each independently represents a hydrogen atom, an alkyl group having 1 to 3 carbon atoms, an aryl group, a hydroxy group, or a hydroxymethylene group, m represents an integer of 1 or more, and n represents an integer of 0 or more; the cyanate ester compound may be a mixture of compounds having different m and n; 1 represents a number of bonded cyanato groups and is each independently an integer of 1 to 3; x represents a number of bonded R₂ and is "a number of possible bonds of Ar₁ - (1 + 2);" and y each independently represents an integer of 0 to 4.
[2] The resin composition according to [1], wherein a content of the cyanate ester compound (A) obtained by cyanating the modified naphthalene formaldehyde resin is 1 to 90 parts by mass when a content of a resin solid in the resin composition is 100 parts by mass.
[3] The resin composition according to [1] or [2], further comprising an inorganic filler (C).
[4] The resin composition according to any one of [1] to [3], further comprising one or more selected from the group consisting of a maleimide compound, a phenolic resin, and a cyanate ester compound other than the cyanate ester compound (A) obtained by cyanating the modified naphthalene formaldehyde resin.
[5] The resin composition according to any one of [1] to [4], wherein the epoxy resin (B) is one or more selected from the group consisting of a biphenyl aralkyl-based epoxy resin, a naphthylene ether-based epoxy resin, a polyfunctional phenol-based epoxy resin, and a naphthalene-based epoxy resin.
[6] The resin composition according to [3], wherein a content of the inorganic filler (C) is 50 to 1600 parts by mass when a content of a resin solid in the resin composition is 100 parts by mass.
[7] A prepreg obtained by impregnating or coating a base material with the resin composition according to any one of [1] to [6].
[8] A metal foil-clad laminate obtained by stacking at least one or more of the prepregs according to [7], disposing metal foil on one surface or both surfaces of an obtained stack, and laminate-molding the metal foil and the stack.
[9] A resin composite sheet obtained by coating a surface of a support with the resin composition according to any one of [1] to [6] and drying the resin composition.
[10] A printed wiring board comprising an insulating layer and a conductor layer formed on a surface of the insulating layer, wherein the insulating layer comprises the resin composition according to any one of [1] to [6].

### Advantages of Invention

According to the present invention, a prepreg, a resin composite sheet, a metal foil-clad laminate, and the like that have not only excellent low water absorbency but also excellent moisture absorption and heat resistance properties and flame retardancy can be realized, and a high performance printed wiring board can be realized. In addition, according to a preferred aspect of the present invention, a resin composition comprising only non-halogen-based compounds (in other words, a resin composition comprising no halogen-based compound or a non-halogen-based resin composition), a prepreg, a resin composite sheet, a metal foil-clad laminate, and the like can also be realized, and their industrial practicality is extremely high.

### Mode for Carrying Out Invention

An embodiment of the present invention (hereinafter also described as "the present embodiment") will be described below.

### <<Resin Composition>>

A resin composition of the present embodiment contains a cyanate ester compound (A) obtained by cyanating a modified naphthalene formaldehyde resin, and an epoxy resin (B).

### <(A) Cyanate Ester Compound>

The cyanate ester compound (A) used in the present embodiment is obtained by cyanating a modified naphthalene formaldehyde resin. The cyanate ester compound (A) has a structure represented by the following general formula (1): 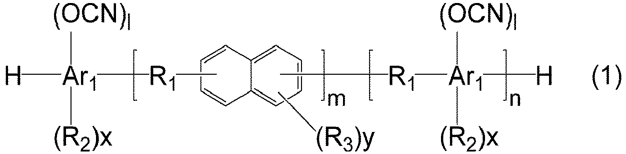 wherein Ar₁ represents an aromatic ring, R₁ each independently represents a methylene group, a methyleneoxy group, a methyleneoxymethylene group, or an oxymethylene group, and the methylene group, the methyleneoxy group, the methyleneoxymethylene group, and the oxymethylene group may be linked; R₂ represents a monovalent substituent and each independently represents a hydrogen atom, an alkyl group, or an aryl group, R₃ each independently represents a hydrogen atom, an alkyl group having 1 to 3 carbon atoms, an aryl group, a hydroxy group, or a hydroxymethylene group, m represents an integer of 1 or more, and n represents an integer of 0 or more; the cyanate ester compound may be a mixture of compounds having different m and n; 1 represents a number of bonded cyanato groups and is each independently an integer of 1 to 3; x represents a number of bonded R₂ and is "a number of possible bonds of Ar₁ - (1 + 2);" and y each independently represents an integer of 0 to 4.

Since the cyanate ester compound (A) is a cyanate ester compound represented by the above general formula (1), the low water absorbency and the flame retardancy tend to be good.

In the above general formula (1), the arrangement of the repeating units is arbitrary. In other words, the compound represented by formula (1) may be a random copolymer or a block copolymer. The upper limit value of m is preferably 50 or less, more preferably 20 or less. The upper limit value of n is preferably 20 or less.

Specific examples of the cyanate ester compound (A) are not particularly limited and include a cyanate (mixture) comprising compounds represented by the following general formulas (2) to (8) as typical compositions.

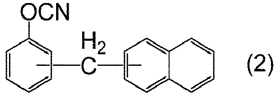

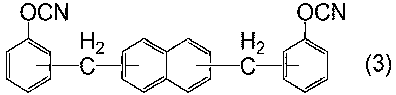

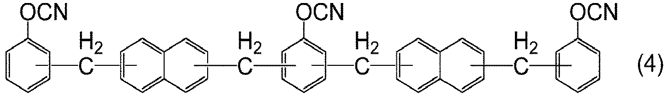

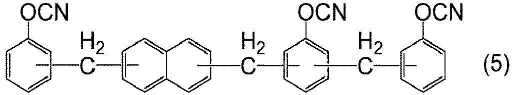

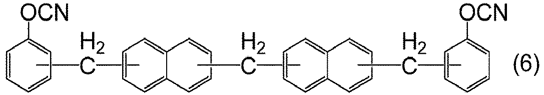

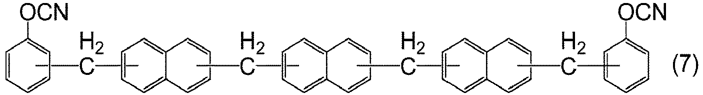

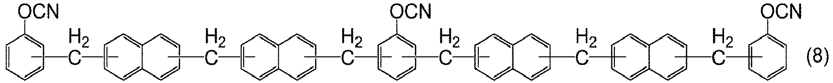

A resin composition comprising a cyanate ester compound obtained by cyanating a modified naphthalene formaldehyde resin and having such structures not only has characteristics excellent in low water absorbency but also has good moisture absorption and heat resistance properties and flame retardancy.

In the present embodiment, the weight average molecular weight Mw of the cyanate ester compound (A) obtained by cyanating the modified naphthalene formaldehyde resin is not particularly limited but is preferably 200 to 25000, more preferably 250 to 20000, and further preferably 300 to 15000. When the weight average molecular weight Mw of the cyanate ester compound (A) is in the above range, the solubility in a solvent tends to be good.

In the present embodiment, the cyanate ester compound (A) is obtained by cyanating hydroxyl groups in a resin structure represented by the following general formula (9). The cyanation method is not particularly limited, and known methods can be applied. Specifically, a method of reacting a modified naphthalene formaldehyde resin and a cyanogen halide in a solvent in the presence of a basic compound, a method of reacting a phenolic resin and a cyanogen halide in a solvent in the presence of a base so that the cyanogen halide is always present in excess of the base (U.S. Patent No. 3553244), a method of adding a tertiary amine and then dropping a cyanogen halide, or dropping both a cyanogen halide and a tertiary amine into a bisphenol compound in the presence of a solvent while using the tertiary amine as a base and using the tertiary amine in excess of the cyanogen halide (Japanese Patent No. 3319061), a method of reacting a phenolic resin, a trialkylamine, and a cyanogen halide in a continuous plug flow mode (Japanese Patent No. 3905559), a method of treating with a cation and anion exchange pair a tert-ammonium halide produced as a by-product in reacting a phenolic resin and a cyanogen halide in a nonaqueous solution in the presence of a tert-amine (Japanese Patent No. 4055210), a method of simultaneously adding a tertiary amine and a cyanogen halide in the presence of a solvent separable from water to react a phenolic resin followed by water washing and separation, and precipitation and purification from the obtained solution using a poor solvent of a secondary or tertiary alcohol or a hydrocarbon (Japanese Patent No. 2991054), and further a method of reacting a naphthol, a cyanogen halide, and a tertiary amine in a two-phase solvent of water and an organic solvent under acidic conditions (Japanese Patent No. 5026727), and the like are known. In the present embodiment, the cyanate ester compound (A) obtained by cyanating a modified naphthalene formaldehyde resin can be obtained preferably using these methods. 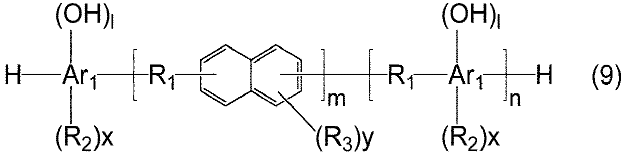 wherein Ar₁ represents an aromatic ring, R₁ each independently represents a methylene group, a methyleneoxy group, a methyleneoxymethylene group, or an oxymethylene group, and the methylene group, the methyleneoxy group, the methyleneoxymethylene group, and the oxymethylene group may be linked; R₂ represents a monovalent substituent and each independently represents a hydrogen atom, an alkyl group, or an aryl group, R₃ each independently represents a hydrogen atom, an alkyl group having 1 to 3 carbon atoms, an aryl group, a hydroxy group, or a hydroxymethylene group, m represents an integer of 1 or more, and n represents an integer of 0 or more; the resin represented by general formula (9) may be a mixture of compounds having different m and n; 1 represents the number of bonded hydroxy groups and is each independently an integer of 1 to 3; x represents the number of bonded R₂ and is "the number of possible bonds of Ar₁ - (1 + 2);" and y each independently represents an integer of 0 to 4.

In the above general formula (9), the arrangement of the repeating units is arbitrary. In other words, the compound of formula (9) may be a random copolymer or a block copolymer. The upper limit value of m is preferably 50 or less, more preferably 20 or less. The upper limit value of n is preferably 20 or less.

The modified naphthalene formaldehyde resin represented by general formula (9) is obtained by heating a naphthalene formaldehyde resin or an acetal bond-removed naphthalene formaldehyde resin and, for example, a hydroxy-substituted aromatic compound as represented by formula (10), in the presence of an acidic catalyst for a modification condensation reaction. When such a modified naphthalene formaldehyde resin is used as a raw material, the low water absorbency and the flame retardancy tend to be good when the cyanate ester compound (A) is used in this resin composition.

Here, the naphthalene formaldehyde resin is a resin obtained by subjecting a naphthalene compound and formaldehyde to a condensation reaction in the presence of an acidic catalyst. In addition, the acetal bond-removed naphthalene formaldehyde resin is a resin obtained by treating a naphthalene formaldehyde resin in the presence of water and an acidic catalyst. 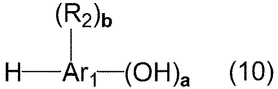 wherein Ar₁ represents an aromatic ring; R₂ represents a monovalent substituent and is each independently a hydrogen atom, an alkyl group, or an aryl group; any position can be selected for the substituents on the above aromatic ring; a represents the number of bonded hydroxy groups and is an integer of 1 to 3; and b represents the number of bonded R₂ and is "the number of possible bonds of Ar₁ - (a + 1)."

In the above general formula (10), examples of the aromatic ring include, but are not particularly limited to, a benzene ring, a naphthalene ring, and an anthracene ring. In addition, examples of the alkyl group of R₂ include, but are not particularly limited to, linear or branched alkyl groups having 1 to 8 carbon atoms, more preferably linear or branched alkyl groups having 1 to 4 carbon atoms, for example, a methyl group, an ethyl group, a propyl group, an isopropyl group, a butyl group, a sec-butyl group, and a tert-butyl group. Further, examples of the aryl group of R₂ include, but are not particularly limited to, a phenyl group, a p-tolyl group, a naphthyl group, and an anthryl group. Specific examples of the hydroxy-substituted aromatic compound represented by the above general formula (10) are not particularly limited and include phenol, 2,6-xylenol, naphthol, dihydroxynaphthalene, biphenol, hydroxyanthracene, and dihydroxyanthracene.

In the method for producing the modified naphthalene formaldehyde resin represented by general formula (9), the main product is, for example, a compound in which naphthalene rings and/or the aromatic rings of a hydroxy-substituted aromatic compound are bonded to each other via a methylene group formed from formaldehyde during modification. The modified naphthalene formaldehyde resin obtained after modification is usually obtained as a mixture of many compounds because the positions at which formaldehyde is bonded to a naphthalene ring and the aromatic ring of the hydroxy-substituted aromatic compound, the position at which a hydroxy group is bonded, the number of polymerizations, and the like are not the same.

For example, a phenol-modified naphthalene formaldehyde resin obtained by modifying with phenol a naphthalene formaldehyde resin obtained from naphthalene or naphthalenemethanol and an aqueous solution of formalin is specifically a mixture comprising compounds represented by the following general formulas (11) to (18) as typical compositions.

In addition, a phenol-modified naphthalene formaldehyde resin obtained by deacetalizing a naphthalene formaldehyde resin obtained from naphthalene or naphthalenemethanol and an aqueous solution of formalin and then modifying the deacetalized naphthalene formaldehyde resin with phenol is specifically a mixture comprising the compounds represented by the following general formulas (11), (12), (13), (15), (16), (17), and (18) as typical compositions.

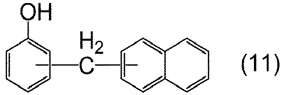

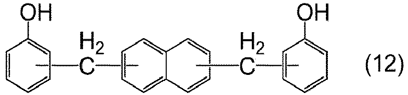

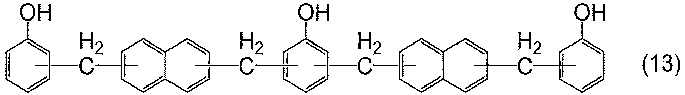

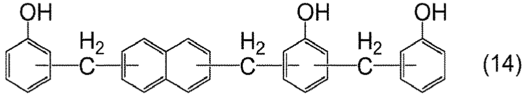

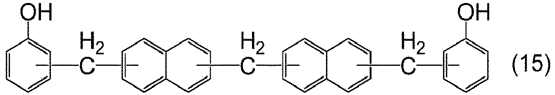

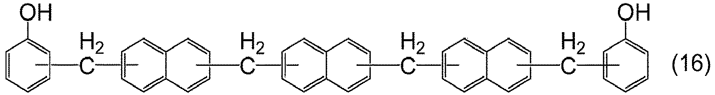

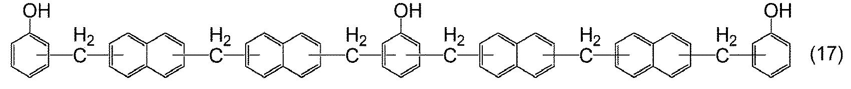

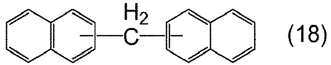

Among these, the aromatic hydrocarbon compound having no hydroxy group in the structure such as the above formula (18) may be removed in advance by distillation separation or the like because it cannot be cyanated.

In the resin composition of the present embodiment, the content of the cyanate ester compound (A) obtained by cyanating the modified naphthalene formaldehyde resin can be appropriately set according to the desired characteristics and is not particularly limited but is preferably 1 to 90 parts by mass, more preferably 10 to 90 parts by mass, and further preferably 30 to 70 parts by mass when a content of a resin solid in the resin composition is 100 parts by mass. When the cyanate ester compound (A) is contained in the above range, the resin composition tends to have improved low water absorbency and curability, and a laminate obtained from the resin composition tends to have improved heat resistance.

Here, "a resin solid in the resin composition" refers to, for example, components in the resin composition excluding a solvent and an inorganic filler (C) unless otherwise noted when the resin composition comprises the solvent and the inorganic filler (C), and 100 parts by mass of a resin solid refers to a total of the components in the resin composition excluding a solvent and an inorganic filler being 100 parts by mass.

### <Epoxy Resin (B)>

For the epoxy resin (B) used in the present embodiment, a known one can be appropriately used as long as it is an epoxy resin having two or more epoxy groups in one molecule. The type of the epoxy resin (B) is not particularly limited. Specific examples of the epoxy resin (B) are not particularly limited and include bisphenol A-based epoxy resins, bisphenol E-based epoxy resins, bisphenol F-based epoxy resins, bisphenol S-based epoxy resins, phenol novolac-based epoxy resins, bisphenol A novolac-based epoxy resins, glycidyl ester-based epoxy resins, aralkyl novolac-based epoxy resins, biphenyl aralkyl-based epoxy resins, naphthylene ether-based epoxy resins, cresol novolac-based epoxy resins, polyfunctional phenol-based epoxy resins, naphthalene-based epoxy resins, anthracene-based epoxy resins, naphthalene skeleton-modified novolac-based epoxy resins, phenol aralkyl-based epoxy resins, naphthol aralkyl-based epoxy resins, dicyclopentadiene-based epoxy resins, biphenyl-based epoxy resins, alicyclic epoxy resins, polyol-based epoxy resins, phosphorus-containing epoxy resins, glycidyl amines, glycidyl esters, compounds obtained by epoxidizing the double bond of butadiene or the like, and compounds obtained by the reaction of a hydroxyl group-containing silicone resin and epichlorohydrin. Among these epoxy resins, biphenyl aralkyl-based epoxy resins, naphthylene ether-based epoxy resins, polyfunctional phenol-based epoxy resins, and naphthalene-based epoxy resins are preferred in terms of flame retardancy and heat resistance. One of these epoxy resins can be used alone, or two or more of these epoxy resins can be used in combination.

The content of the epoxy resin (B) used in the present embodiment can be appropriately set according to the desired characteristics and is not particularly limited but is preferably 10 to 99 parts by mass, more preferably 10 to 90 parts by mass, and further preferably 30 to 70 parts by mass when the content of the resin solid in the resin composition is 100 parts by mass. When the epoxy resin (B) is contained in the above range, the obtained resin composition tends to have excellent curability and heat resistance.

The resin composition of the present embodiment can also further contain the inorganic filler (C). As the inorganic filler (C), a known one can be appropriately used, and the type of the inorganic filler (C) is not particularly limited. Inorganic fillers generally used in laminate applications can be preferably used. Specific examples of the inorganic filler (C) are not particularly limited and include inorganic fillers such as silicas such as natural silica, fused silica, synthetic silica, amorphous silica, AEROSIL, and hollow silica, white carbon, titanium white, zinc oxide, magnesium oxide, zirconium oxide, boron nitride, aggregated boron nitride, silicon nitride, aluminum nitride, barium sulfate, metal hydrates such as aluminum hydroxide, heat-treated products of aluminum hydroxide (products obtained by heat-treating aluminum hydroxide to decrease some of the water of crystallization), boehmite, and magnesium hydroxide, molybdenum compounds such as molybdenum oxide and zinc molybdate, zinc borate, zinc stannate, alumina, clay, kaolin, talc, calcined clay, calcined kaolin, calcined talc, mica, E-glass, A-glass, NE-glass, C-glass, L-glass, D-glass, S-glass, M-glass G20, glass short fibers (including fine powders of glass such as E glass, T glass, D glass, S glass, and Q glass), hollow glass, and spherical glass as well as organic fillers such as rubber powders such as styrene-based rubber powders, butadiene-based rubber powders, and acrylic-based rubber powders, core-shell-based rubber powders, silicone resin powders, silicone rubber powders, and silicone composite powders. One of these inorganic fillers can be used alone, or two or more of these inorganic fillers can be used in combination.

The content of the inorganic filler (C) used in the present embodiment can be appropriately set according to the desired characteristics and is not particularly limited but is preferably 50 to 1600 parts by mass, more preferably 50 to 300 parts by mass, and further preferably 50 to 200 parts by mass when the content of the resin solid in the resin composition is 100 parts by mass.

Here, in using the inorganic filler (C), a silane coupling agent and a wetting and dispersing agent are preferably used in combination. As the silane coupling agent, those generally used for the surface treatment of inorganic matter can be preferably used, and the type of the silane coupling agent is not particularly limited. Specific examples of the silane coupling agent are not particularly limited and include aminosilane-based silane coupling agents such as γ-aminopropyltriethoxysilane and N-β-(aminoethyl)-γ-aminopropyltrimethoxysilane, epoxysilane-based silane coupling agents such as γ-glycidoxypropyltrimethoxysilane and β-(3,4-epoxycyclohexyl)ethyltrimethoxysilane, vinylsilane-based silane coupling agents such as γ-methacryloxypropyltrimethoxysilane and vinyl-tri(β-methoxyethoxy)silane, cationic silane-based silane coupling agents such as N-β-(N-vinylbenzylaminoethyl)-γ-aminopropyltrimethoxysilane hydrochloride, and phenylsilane-based silane coupling agents. One silane coupling agent can be used alone, or two or more silane coupling agents can be used in combination. In addition, as the wetting and dispersing agent, those generally used for paints can be preferably used, and the type of the wetting and dispersing agent is not particularly limited. As the wetting and dispersing agent, preferably, copolymer-based wetting and dispersing agents are used. Specific examples of the wetting and dispersing agent are not particularly limited and include Disperbyk-110, 111, 161, and 180, BYK-W996, BYK-W9010, BYK-W903, and BYK-W940 manufactured by BYK Japan KK. One wetting and dispersing agent can be used alone, or two or more wetting and dispersing agents can be used in combination.

### <Curing Accelerator>

In addition, the resin composition of the present embodiment may contain a curing accelerator for appropriately adjusting the curing rate, as required. As this curing accelerator, those generally used as curing accelerators for cyanate ester compounds, epoxy resins, and the like can be preferably used, and the type of the curing accelerator is not particularly limited. Specific examples of the curing accelerator are not particularly limited and include organometallic salts such as zinc octylate, zinc naphthenate, cobalt naphthenate, copper naphthenate, acetylacetone iron, nickel octylate, and manganese octylate, phenol compounds such as phenol, xylenol, cresol, resorcin, catechol, octyl phenol, and nonyl phenol, alcohols such as 1-butanol and 2-ethylhexanol, imidazoles such as 2-methylimidazole, 2-ethyl-4-methylimidazole, 2-phenylimidazole, 1-cyanoethyl-2-phenylimidazole, 1-cyanoethyl-2-ethyl-4-methylimidazole, 2-phenyl-4,5-dihydroxymethylimidazole, and 2-phenyl-4-methyl-5-hydroxymethylimidazole and derivatives, such as adducts with carboxylic acids or acid anhydride thereof, of these imidazoles, amines such as dicyandiamide, benzyldimethylamine, and 4-methyl-N,N-dimethylbenzylamine, phosphorus compounds such as phosphine-based compounds, phosphine oxide-based compounds, phosphonium salt-based compounds, and diphosphine-based compounds, epoxy-imidazole adduct-based compounds, peroxides such as benzoyl peroxide, p-chlorobenzoyl peroxide, di-t-butyl peroxide, diisopropyl peroxycarbonate, and di-2-ethylhexyl peroxycarbonate, or azo compounds such as azobisisobutyronitrile. One curing accelerator can be used alone, or two or more curing accelerators can be used in combination.

The amount of the curing accelerator used can be appropriately adjusted considering the degree of cure of the resins, the viscosity of the resin composition, and the like and is not particularly limited but is usually preferably about 0.005 to 10 parts by mass based on 100 parts by mass of the resin solid in the resin composition.

### <Other Components>

The resin composition of the present embodiment may contain a cyanate ester compound other than the cyanate ester compound (A) obtained by cyanating a modified naphthalene formaldehyde resin (hereinafter also referred to as "another cyanate ester compound"), a maleimide compound, a phenolic resin, an oxetane resin, a benzoxazine compound, and/or a compound having a polymerizable unsaturated group, and the like in a range in which the expected characteristics are not impaired. Especially, the resin composition of the present embodiment preferably contains one or more selected from the group consisting of a maleimide compound, a phenolic resin, and a cyanate ester compound other than the cyanate ester compound (A) obtained by cyanating a modified naphthalene formaldehyde resin. When the resin composition of the present embodiment contains such compounds, the heat resistance tends to be able to be improved.

The another cyanate ester compound is not particularly limited as long as it is a resin having an aromatic moiety substituted by at least one cyanato group in the molecule. Examples thereof include a cyanate ester compound represented by general formula (19): 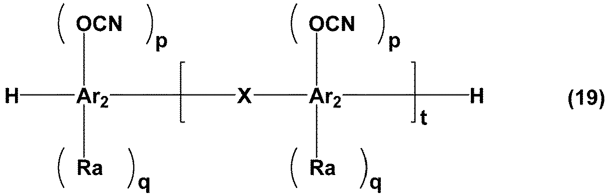 wherein Ar₂ represents a phenylene group, a naphthylene group, or a biphenylene group; Ra each independently represents a hydrogen atom, an alkyl group having 1 to 6 carbon atoms, an aryl group having 6 to 12 carbon atoms, an alkoxy group having 1 to 4 carbon atoms, or a group in which an alkyl group having 1 to 6 carbon atoms and an aryl group having 6 to 12 carbon atoms are mixed; any position can be selected for the substituents on the aromatic ring; p represents the number of bonded cyanato groups and is each independently an integer of 1 to 3; q represents the number of bonded Ra and is each independently 4 - p when Ar₂ is a phenylene group, 6 - p when Ar₂ is a naphthylene group, and 8 - p when Ar₂ is a biphenylene group; t represents an integer of 0 to 50, and the cyanate ester compound may be a mixture of compounds having different t; and X represents any of a single bond, a divalent organic group having 1 to 20 carbon atoms (a hydrogen atom may be replaced by a heteroatom), a divalent organic group having 1 to 10 nitrogen atoms (-N-R-N- or the like wherein R represents an organic group), a carbonyl group (-CO-), a carboxy group (-C(=O)O-), a carbonyl dioxide group (-OC(=O)O-), a sulfonyl group (-SO₂-), and a divalent sulfur atom or oxygen atom.

The alkyl group for Ra in general formula (19) may have either a chain structure or a cyclic structure (a cycloalkyl group or the like).

In addition, a hydrogen atom in the alkyl group in general formula (19) and the aryl group for Ra may be replaced by a halogen atom such as fluorine or chlorine, an alkoxy group such as a methoxy group or a phenoxy group, a cyano group, or the like.

Specific examples of the above alkyl group are not particularly limited and include a methyl group, an ethyl group, a propyl group, an isopropyl group, a n-butyl group, an isobutyl group, a tert-butyl group, a n-pentyl group, a 1-ethylpropyl group, a 2,2-dimethylpropyl group, a cyclopentyl group, a hexyl group, a cyclohexyl group, and a trifluoromethyl group.

Specific examples of the above aryl group are not particularly limited and include a phenyl group, a xylyl group, a mesityl group, a naphthyl group, a phenoxyphenyl group, an ethylphenyl group, an o-, m-, or p-fluorophenyl group, a dichlorophenyl group, a dicyanophenyl group, a trifluorophenyl group, a methoxyphenyl group, and an o-, m-, or p-tolyl group. Further, examples of the alkoxy group include a methoxy group, an ethoxy group, a propoxy group, an isopropoxy group, a n-butoxy group, an isobutoxy group, and a tert-butoxy group.

Specific examples of the divalent organic group for X in general formula (19) are not particularly limited and include a methylene group, an ethylene group, a trimethylene group, a propylene group, a cyclopentylene group, a cyclohexylene group, a trimethylcyclohexylene group, a biphenylylmethylene group, a dimethylmethylene-phenylene-dimethylmethylene group, a fluorenediyl group, and a phthalidediyl group. A hydrogen atom in the divalent organic group may be replaced by a halogen atom such as fluorine or chlorine, an alkoxy group such as a methoxy group or a phenoxy group, a cyano group, or the like.

The divalent organic group having 1 to 10 nitrogen atoms for X in general formula (19) is not particularly limited. Examples thereof include an imino group and a polyimide group.

In addition, X in general formula (19) is not particularly limited. Examples thereof include a structure represented by the following general formula (20) or structures represented by the following formulas. 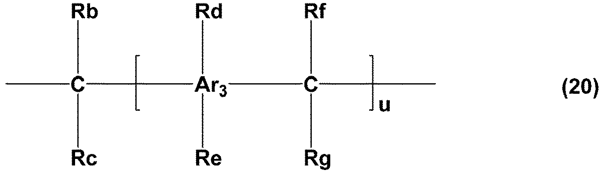 wherein Ar₃ represents a phenylene group, a naphthylene group, or a biphenylene group; Rb, Rc, Rf, and Rg each independently represent a hydrogen atom, an alkyl group having 1 to 6 carbon atoms, an aryl group having 6 to 12 carbon atoms, a trifluoromethyl group, or an aryl group substituted by at least one phenolic hydroxyl group; Rd and Re each independently represent a hydrogen atom, an alkyl group having 1 to 6 carbon atoms, an aryl group having 6 to 12 carbon atoms, an alkoxy group having 1 to 4 carbon atoms, or a hydroxyl group; and u represents an integer of 0 to 5 and may be the same or different. 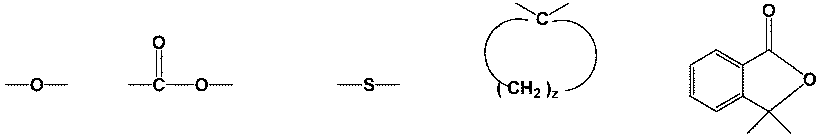 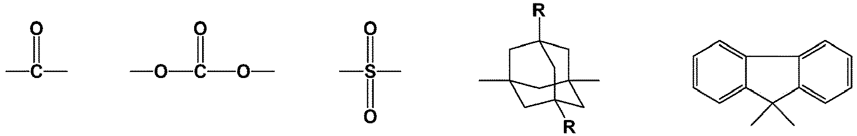 wherein z represents an integer of 4 to 7; and R each independently represents a hydrogen atom or an alkyl group having 1 to 6 carbon atoms.

Specific examples of Ar₃ in general formula (20) are not particularly limited and include a 1,4-phenylene group, a 1,3-phenylene group, a 4,4'-biphenylene group, a 2,4'-biphenylene group, a 2,2'-biphenylene group, a 2,3'-biphenylene group, a 3,3'-biphenylene group, a 3,4'-biphenylene group, a 2,6-naphthylene group, a 1,5-naphthylene group, a 1,6-naphthylene group, a 1,8-naphthylene group, a 1,3-naphthylene group, and a 1,4-naphthylene group.

The alkyl group and the aryl group for Rb to Rf in general formula (20) are similar to those described in general formula (19).

Specific examples of the resin having an aromatic moiety substituted by at least one cyanato group in the molecule represented by general formula (19) include cyanatobenzene, 1-cyanato-2-, 1-cyanato-3-, or 1-cyanato-4-methylbenzene, 1-cyanato-2-, 1-cyanato-3-, or 1-cyanato-4-methoxybenzene, 1-cyanato-2,3-, 1-cyanato-2,4-, 1-cyanato-2,5-, 1-cyanato-2,6-, 1-cyanato-3,4-, or 1-cyanato-3,5-dimethylbenzene, cyanatoethylbenzene, cyanatobutylbenzene, cyanatooctylbenzene, cyanatononylbenzene, 2-(4-cyanatophenyl)-2-phenylpropane (a cyanate ester of 4-α-cumylphenol), 1-cyanato-4-cyclohexylbenzene, 1-cyanato-4-vinylbenzene, 1-cyanato-2- or 1-cyanato-3-chlorobenzene, 1-cyanato-2,6-dichlorobenzene, 1-cyanato-2-methyl-3-chlorobenzene, cyanatonitrobenzene, 1-cyanato-4-nitro-2-ethylbenzene, 1-cyanato-2-methoxy-4-allylbenzene (a cyanate ester of eugenol), methyl(4-cyanatophenyl)sulfide, 1-cyanato-3-trifluoromethylbenzene, 4-cyanatobiphenyl, 1-cyanato-2- or 1-cyanato-4-acetylbenzene, 4-cyanatobenzaldehyde, methyl 4-cyanatobenzoate ester, phenyl 4-cyanatobenzoate ester, 1-cyanato-4-acetaminobenzene, 4-cyanatobenzophenone, 1-cyanato-2,6-di-tert-butylbenzene, 1,2-dicyanatobenzene, 1,3-dicyanatobenzene, 1,4-dicyanatobenzene, 1,4-dicyanato-2-tert-butylbenzene, 1,4-dicyanato-2,4-dimethylbenzene, 1,4-dicyanato-2,3,4-dimethylbenzene, 1,3-dicyanato-2,4,6-trimethylbenzene, 1,3-dicyanato-5-methylbenzene, 1-cyanato- or 2-cyanatonaphthalene, 1-cyanato4-methoxynaphthalene, 2-cyanato-6-methylnaphthalene, 2-cyanato-7-methoxynaphthalene, 2,2'-dicyanato-1,1'-binaphthyl, 1,3-, 1,4-, 1,5-, 1,6-, 1,7-, 2,3-, 2,6-, or 2,7-dicyanatonaphthalene, 2,2'- or 4,4'-dicyanatobiphenyl, 4,4'-dicyanatooctafluorobiphenyl, 2,4'- or 4,4'-dicyanatodiphenylmethane, bis(4-cyanato-3,5-dimethylphenyl)methane, 1,1-bis(4-cyanatophenyl)ethane, 1,1-bis(4-cyanatophenyl)propane, 2,2-bis(4-cyanatophenyl)propane, 2,2-bis(4-cyanato-3-methylphenyl)propane, 2,2-bis(2-cyanato-5-biphenylyl)propane, 2,2-bis(4-cyanatophenyl)hexafluoropropane, 2,2-bis(4-cyanato-3,5-dimethylphenyl)propane, 1,1-bis(4-cyanatophenyl)butane, 1,1-bis(4-cyanatophenyl)isobutane, 1,1-bis(4-cyanatophenyl)pentane, 1,1-bis(4-cyanatophenyl)-3-methylbutane, 1,1-bis(4-cyanatophenyl)-2-methylbutane, 1,1-bis(4-cyanatophenyl)-2,2-dimethylpropane, 2,2-bis(4-cyanatophenyl)butane, 2,2-bis(4-cyanatophenyl)pentane, 2,2-bis(4-cyanatophenyl)hexane, 2,2-bis(4-cyanatophenyl)-3-methylbutane, 2,2-bis(4-cyanatophenyl)-4-methylpentane, 2,2-bis(4-cyanatophenyl)-3,3-dimethylbutane, 3,3-bis(4-cyanatophenyl)hexane, 3,3-bis(4-cyanatophenyl)heptane, 3,3-bis(4-cyanatophenyl)octane, 3,3-bis(4-cyanatophenyl)-2-methylpentane, 3,3-bis(4-cyanatophenyl)-2-methylhexane, 3,3-bis(4-cyanatophenyl)-2,2-dimethylpentane, 4,4-bis(4-cyanatophenyl)-3-methylheptane, 3,3-bis(4-cyanatophenyl)-2-methylheptane, 3,3-bis(4-cyanatophenyl)-2,2-dimethylhexane, 3,3-bis(4-cyanatophenyl)-2,4-dimethylhexane, 3,3-bis(4-cyanatophenyl)-2,2,4-trimethylpentane, 2,2-bis(4-cyanatophenyl)-1,1,1,3,3,3-hexafluoropropane, bis(4-cyanatophenyl)phenylmethane, 1,1-bis(4-cyanatophenyl)-1-phenylethane, bis(4-cyanatophenyl)biphenylmethane, 1,1-bis(4-cyanatophenyl)cyclopentane, 1,1-bis(4-cyanatophenyl)cyclohexane, 2,2-bis(4-cyanato-3-isopropylphenyl)propane, 1,1-bis(3-cyclohexyl-4-cyanatophenyl)cyclohexane, bis(4-cyanatophenyl)diphenylmethane, bis(4-cyanatophenyl)-2,2-dichloroethylene, 1,3-bis[2-(4-cyanatophenyl)-2-propyl]benzene, 1,4-bis[2-(4-cyanatophenyl)-2-propyl]benzene, 1,1-bis(4-cyanatophenyl)-3,3,5-trimethylcyclohexane, 4-[bis(4-cyanatophenyl)methyl]biphenyl, 4,4-dicyanatobenzophenone, 1,3-bis(4-cyanatophenyl)-2-propen-1-one, bis(4-cyanatophenyl)ether, bis(4-cyanatophenyl)sulfide, bis(4-cyanatophenyl)sulfone, 4-cyanatobenzoic acid-4-cyanatophenyl ester (4-cyanatophenyl-4-cyanatobenzoate), bis-(4-cyanatophenyl)carbonate, 1,3-bis(4-cyanatophenyl)adamantane, 1,3-bis(4-cyanatophenyl)-5,7-dimethyladamantane, 3,3-bis(4-cyanatophenyl)isobenzofuran-1(3H)-one (a cyanate ester of phenolphthalein), 3,3-bis(4-cyanato-3-methylphenyl)isobenzofuran-1(3H)-one (a cyanate ester of o-cresolphthalein), 9,9'-bis(4-cyanatophenyl)fluorene, 9,9-bis(4-cyanato-3-methylphenyl)fluorene, 9,9-bis(2-cyanato-5-biphenylyl)fluorene, tris(4-cyanatophenyl)methane, 1,1,1-tris(4-cyanatophenyl)ethane, 1,1,3-tris(4-cyanatophenyl)propane, α,α,α'-tris(4-cyanatophenyl)-1-ethyl-4-isopropylbenzene, 1,1,2,2-tetrakis(4-cyanatophenyl)ethane, tetrakis(4-cyanatophenyl)methane, 2,4,6-tris(N-methyl-4-cyanatoanilino)-1,3,5-triazine, 2,4-bis(N-methyl-4-cyanatoanilino)-6-(N-methylanilino)-1,3,5-triazine, bis(N-4-cyanato-2-methylphenyl)-4,4'-oxydiphthalimide, bis(N-3-cyanato-4-methylphenyl)-4,4'-oxydiphthalimide, bis(N-4-cyanatophenyl)-4,4'-oxydiphthalimide, bis(N-4-cyanato-2-methylphenyl)-4,4'-(hexafluoroisopropylidene)diphthalimide, tris(3,5-dimethyl-4-cyanatobenzyl)isocyanurate, 2-phenyl-3,3-bis(4-cyanatophenyl)phthalimidine, 2-(4-methylphenyl)-3,3-bis(4-cyanatophenyl)phthalimidine, 2-phenyl-3,3-bis(4-cyanato-3-methylphenyl)phthalimidine, 1-methyl-3,3-bis(4-cyanatophenyl)indolin-2-one, 2-phenyl-3,3-bis(4-cyanatophenyl)indolin-2-one, and products obtained by cyanating phenolic resins such as phenol novolac resins and cresol novolac resins (those obtained by reacting a phenol, an alkyl-substituted phenol, or a halogen-substituted phenol and a formaldehyde compound such as formalin or paraformaldehyde in an acidic solution by a known method), phenol aralkyl resins, cresol aralkyl resins, naphthol aralkyl resins, and biphenyl aralkyl resins (those obtained by reacting a bishalogenomethyl compound as represented by Ar₃-(CH₂Y)₂ and a phenol compound with an acidic catalyst or without a catalyst by a known method, and those obtained by reacting a bis(alkoxymethyl) compound as represented by Ar₃-(CH₂OR)₂ or a bis(hydroxymethyl) compound as represented by Ar₃-(CH₂OH)₂ and a phenol compound in the presence of an acidic catalyst by a known method), phenol-modified xylene formaldehyde resins (those obtained by reacting a xylene formaldehyde resin and a phenol compound in the presence of an acidic catalyst by a known method), and phenol-modified dicyclopentadiene resins by a method similar to the above, and prepolymers thereof, but are not particularly limited. One of these cyanate ester compounds can be used, or two or more of these cyanate ester compounds can be mixed and used.

As the maleimide compound, those generally known can be used as long as they are compounds having one or more maleimide groups in one molecule. Specific examples of the maleimide compound include 4,4-diphenylmethanebismaleimide, phenylmethanemaleimide, m-phenylenebismaleimide, 2,2-bis(4-(4-maleimidophenoxy)-phenyl)propane, 3,3-dimethyl-5,5-diethyl-4,4-diphenylmethanebismaleimide, 4-methyl-1,3-phenylenebismaleimide, 1,6-bismaleimido-(2,2,4-trimethyl)hexane, 4,4-diphenyl ether bismaleimide, 4,4-diphenyl sulfone bismaleimide, 1,3-bis(3-maleimidophenoxy)benzene, 1,3-bis(4-maleimidophenoxy)benzene, polyphenylmethanemaleimide, and prepolymers of these maleimide compounds or prepolymers of maleimide compounds and amine compounds but are not particularly limited. One of these maleimide compounds can be used, or two or more of these maleimide compounds can be mixed and used.

As the phenolic resin, those generally known can be used as long as they are phenolic resins having two or more hydroxyl groups in one molecule. Specific examples of the phenolic resin include bisphenol A-based phenolic resins, bisphenol E-based phenolic resins, bisphenol F-based phenolic resins, bisphenol S-based phenolic resins, phenol novolac resins, bisphenol A novolac-based phenolic resins, glycidyl ester-based phenolic resins, aralkyl novolac-based phenolic resins, biphenyl aralkyl-based phenolic resins, cresol novolac-based phenolic resins, polyfunctional phenolic resins, naphthol resins, naphthol novolac resins, polyfunctional naphthol resins, anthracene-based phenolic resins, naphthalene skeleton-modified novolac-based phenolic resins, phenol aralkyl-based phenolic resins, naphthol aralkyl-based phenolic resins, dicyclopentadiene-based phenolic resins, biphenyl-based phenolic resins, alicyclic phenolic resins, polyol-based phenolic resins, phosphorus-containing phenolic resins, and hydroxyl group-containing silicone resins but are not particularly limited. One of these phenolic resins can be used alone, or two or more of these phenolic resins can be used in combination.

As the oxetane resin, those generally known can be used. Specific examples of the oxetane resin include oxetane, alkyloxetanes such as 2-methyloxetane, 2,2-dimethyloxetane, 3-methyloxetane, and 3,3-dimethyloxetane, 3-methyl-3-methoxymethyloxetane, 3,3'-di(trifluoromethyl)perfluoxetane, 2-chloromethyloxetane, 3,3-bis(chloromethyl)oxetane, biphenyl-based oxetane, OXT-101 (trade name manufactured by Toagosei Co., Ltd.), and OXT-121 (trade name manufactured by Toagosei Co., Ltd.), but are not particularly limited. One of these oxetane resins can be used, or two or more of these oxetane resins can be mixed and used.

As the benzoxazine compound, those generally known can be used as long as they are compounds having two or more dihydrobenzoxazine rings in one molecule. Specific examples of the benzoxazine compound include bisphenol A-based benzoxazine BA-BXZ (trade name manufactured by Konishi Chemical Ind. Co., Ltd.), bisphenol F-based benzoxazine BF-BXZ (trade name manufactured by Konishi Chemical Ind. Co., Ltd.), and bisphenol S-based benzoxazine BS-BXZ (trade name manufactured by Konishi Chemical Ind. Co., Ltd.), but are not particularly limited. One of these benzoxazine compounds can be used, or two or more of these benzoxazine compounds can be mixed and used.

As the compound having a polymerizable unsaturated group, those generally known can be used. Specific examples of the compound having a polymerizable unsaturated group include vinyl compounds such as ethylene, propylene, styrene, divinylbenzene, and divinylbiphenyl, (meth)acrylates of monohydric or polyhydric alcohols such as methyl (meth)acrylate, 2-hydroxyethyl (meth)acrylate, 2-hydroxypropyl (meth)acrylate, polypropylene glycol di(meth)acrylate, trimethylolpropane di(meth)acrylate, trimethylolpropane tri(meth)acrylate, pentaerythritol tetra(meth)acrylate, and dipentaerythritol hexa(meth)acrylate, epoxy (meth)acrylates such as bisphenol A-based epoxy (meth)acrylate and bisphenol F-based epoxy (meth)acrylate, benzocyclobutene resins, and (bis)maleimide resins, but are not particularly limited. One of these compounds having an unsaturated group can be used, or two or more of these compounds having an unsaturated group can be mixed and used.

Further, the resin composition of the present embodiment can use various polymer compounds such as another thermosetting resin, a thermoplastic resin and an oligomer thereof, and an elastomer, a flame-retardant compound, various additives, and the like in combination in a range in which the expected characteristics are not impaired. These are not particularly limited as long as they are those generally used. The flame-retardant compound is not particularly limited. Examples thereof include bromine compounds such as 4,4'-dibromobiphenyl, phosphates, melamine phosphate, phosphorus-containing epoxy resins, nitrogen compounds such as melamine and benzoguanamine, oxazine ring-containing compounds, and silicone-based compounds. In addition, the various additives are not particularly limited. Examples thereof include ultraviolet absorbing agents, antioxidants, photopolymerization initiators, fluorescent brightening agents, photosensitizers, dyes, pigments, thickening agents, flow-adjusting agents, lubricants, defoaming agents, dispersing agents, leveling agents, brightening agents, and polymerization inhibitors. One of these can be used alone or two or more of these can be used in combination as desired.

The resin composition of the present embodiment can contain an organic solvent as required. In this case, the resin composition of the present embodiment can be used as a form (solution or varnish) in which at least some, preferably all, of the above-described various resin components are dissolved in or compatible with the organic solvent. As the organic solvent, a known one can be appropriately used as long as it can dissolve or be compatible with at least some, preferably all, of the above-described various resin components. The type of the organic solvent is not particularly limited. Specific examples of the organic solvent are not particularly limited and include polar solvents such as ketones such as acetone, methyl ethyl ketone, and methyl isobutyl ketone, cellosolve-based solvents such as propylene glycol monomethyl ether and propylene glycol monomethyl ether acetate, ester-based solvents such as ethyl lactate, methyl acetate, ethyl acetate, butyl acetate, isoamyl acetate, ethyl lactate, methyl methoxypropionate, and methyl hydroxyisobutyrate, and amides such as dimethylacetamide and dimethylformamide, and nonpolar solvents such as aromatic hydrocarbons such as toluene and xylene. One of these can be used alone, or two or more of these can be used in combination.

### <<Applications>>

The resin composition of the present embodiment can be used, for example, as the insulating layer of a printed wiring board and a semiconductor package material. For example, a prepreg can be provided by impregnating or coating a base material with a solution of the resin composition of the present embodiment dissolved in a solvent and drying the solution.

In addition, for example, a buildup film or a dry film solder resist can be provided by using a peelable plastic film as a base material, coating the plastic film with a solution of the resin composition of the present embodiment dissolved in a solvent, and drying the solution. Here, the solvent can be dried, for example, by heating at a temperature of 20°C to 150°C for 1 to 90 minutes. In addition, the resin composition can also be used in an uncured state in which the solvent is only dried, or in a semi-cured (B-staged) state as required.

### <Prepreg>

A prepreg of the present embodiment will be described in detail below. The prepreg of the present embodiment is obtained by impregnating or coating a base material with the above-described resin composition. The method for producing the prepreg of the present embodiment is not particularly limited as long as it is a method of combining the above-described resin composition and a base material to produce a prepreg. Specifically, for example, the prepreg of the present embodiment can be produced by impregnating or coating a base material with the above-described resin composition and then semi-curing the resin composition by a method of drying at 120 to 220°C for about 2 to 15 minutes, or the like. At this time, the amount of the resin composition adhered to the base material, that is, the amount of the resin composition (containing the inorganic filler (C)) based on the total amount of the prepreg after the semi-curing, is preferably in the range of 20 to 99% by mass.

As the base material used when the prepreg of the present embodiment is produced, known ones used for various printed wiring board materials can be used. Specific examples of the base material include, but are not particularly limited to, woven cloths of fibers of glass such as E glass, D glass, L glass, S glass, T glass, Q glass, UN glass, NE glass, and spherical glass, inorganic fibers of materials other than glass such as quartz, organic fibers of polyimides, polyamides, polyesters, and the like, liquid crystal polyesters, and the like. As the shape of the base material, woven cloths, nonwoven cloths, rovings, chopped strand mats, surfacing mats, and the like are known, and the shape of the base material may be any. One base material can be used alone, or two or more base materials can be used in combination. In addition, the thickness of the base material is not particularly limited but is preferably in the range of 0.01 to 0.2 mm in laminate applications. Particularly, woven cloths subjected to ultra-opening treatment or clogging treatment are preferred from the viewpoint of dimensional stability. Further, glass woven cloths surface-treated with a silane coupling agent for epoxysilane treatment, aminosilane treatment, or the like are preferred from the viewpoint of moisture absorption and heat resistance properties. In addition, liquid crystal polyester woven cloths are preferred in terms of electrical characteristics.

### <Metal Foil-Clad Laminate>

On the other hand, a metal foil-clad laminate of the present embodiment is obtained by stacking at least one or more of the above-described prepregs, disposing metal foil on one surface or both surfaces of the obtained stack, and laminate-molding the metal foil and the stack. Specifically, the metal foil-clad laminate of the present embodiment can be fabricated, for example, by stacking one or a plurality of the above-described prepregs, disposing foil of a metal such as copper or aluminum on one surface or both surfaces of the obtained stack, and laminate-molding the metal foil and the stack. The metal foil used here is not particularly limited as long as it is metal foil used for a printed wiring board material. Copper foil such as rolled copper foil and electrolytic copper foil is preferred. In addition, the thickness of the metal foil is not particularly limited but is preferably 2 to 70 µm, more preferably 3 to 35 µm. As the molding conditions, usual methods for laminates and multilayer boards for printed wiring boards can be applied. For example, the metal foil-clad laminate of the present embodiment can be produced by laminate-molding with a temperature of 180 to 350°C, a heating time of 100 to 300 minutes, and a surface pressure of 20 to 100 kg/cm² using a multistage press, a multistage vacuum press, a continuous molding machine, an autoclave molding machine, or the like. In addition, a multilayer board can also be provided by laminate-molding the above prepreg and a separately fabricated wiring board for an inner layer in combination. The method for producing a multilayer board is not particularly limited. Examples thereof can include a method of fabricating a multilayer board by disposing 35 µm copper foil on both surfaces of one of the above-described prepreg, laminate-molding the copper foil and the prepreg under the above conditions, then forming inner layer circuits, subjecting these circuits to blackening treatment to form an inner layer circuit board, then alternately disposing these inner layer circuit boards and the above prepregs one by one, further disposing copper foil on the outermost layers, and laminate-molding the copper foil, the inner layer circuit boards, and the prepregs under the above conditions preferably under vacuum.

The metal foil-clad laminate of the present embodiment can be preferably used, for example, as a printed wiring board. The printed wiring board can be produced according to an ordinary method, and the method for producing the printed wiring board is not particularly limited. One example of a method for producing a printed wiring board will be shown below. First, a metal foil-clad laminate such as the above-described copper-clad laminate is provided. Next, the surfaces of the metal foil-clad laminate are subjected to etching treatment to form inner layer circuits to fabricate an inner layer substrate. The inner layer circuit surfaces of this inner layer substrate are subjected to surface treatment for increasing adhesive strength, as required. Then, the required number of the above-described prepregs are stacked on the inner layer circuit surfaces, metal foil for outer layer circuits is further laminated on the outside of the stack, and heat and pressure are applied for integral molding. In this manner, a multilayer laminate in which insulating layers comprising a base material and a cured product of the above-described resin composition are formed between inner layer circuits and metal foil for outer layer circuits is produced. Then, this multilayer laminate is subjected to drilling for through holes and via holes, and then a plated metal film that allows conduction between the inner layer circuits and the metal foil for outer layer circuits is formed on the wall surfaces of these holes. Further, the metal foil for outer layer circuits is subjected to etching treatment to form outer layer circuits. Thus, a printed wiring board is produced.

The printed wiring board obtained in the above production example has a configuration in which it has insulating layers and conductor layers formed on surfaces of these insulating layers, and the insulating layers comprise the above-described resin composition. In other words, the resin composition in the above-described prepreg (the base material and the above-described resin composition with which the base material is impregnated or coated) and the resin composition layer of the above-described metal foil-clad laminate (the layer comprising the above-described resin composition) are composed of an insulating layer comprising the above-described resin composition.

### <Resin Composite Sheet>

On the other hand, a resin composite sheet of the present embodiment is obtained by coating a surface of a support with the above-described resin composition and drying the resin composition. The resin composite sheet of the present embodiment can be obtained, for example, by coating a support with a solution of the above resin composition dissolved in a solvent and drying the solution. Examples of the support used here include organic film base materials such as polyethylene films, polypropylene films, polycarbonate films, polyethylene terephthalate films, ethylene-tetrafluoroethylene copolymer films, and release films obtained by coating surfaces of these films with a release agent, and polyimide films, conductor foil such as copper foil and aluminum foil, and plate-shaped supports such as glass plates, SUS plates, and FRP but are not particularly limited. The coating method is not particularly limited. Examples thereof include a method of coating a support with a solution of the above-described resin composition dissolved in a solvent by a bar coater, a die coater, a doctor blade, a baker applicator, or the like. In addition, a single-layer sheet (resin sheet) can also be provided by peeling or etching the support from the laminated sheet after drying. A single-layer sheet (resin sheet) can also be obtained without using a support by supplying a solution of the above resin composition dissolved in a solvent into a mold having a sheet-shaped cavity, drying the solution, and so on for molding into a sheet shape.

In the fabrication of the above-described single-layer or laminated sheet, the drying conditions when the solvent is removed are not particularly limited but are preferably a temperature of 20°C to 200°C for 1 to 90 minutes because at low temperature, the solvent is likely to remain in the resin composition, and at high temperature, the curing of the resin composition proceeds. In addition, the thickness of the resin layer of the above-described single-layer or laminated sheet can be adjusted by the concentration and coating thickness of the solution of the above-described resin composition and is not particularly limited but is preferably 0.1 to 500 µm because generally, when the coating thickness increases, the solvent is likely to remain during drying. Examples

The present invention will be described in more detail below by showing Synthesis Examples, Examples, and Comparative Examples.

### (Measurement of Weight Average Molecular Weight Mw of Cyanate Ester Compound)

10 µL of a solution of 1 g of a cyanate ester compound dissolved in 100 g of tetrahydrofuran (solvent) was injected into high performance liquid chromatography (high performance liquid chromatograph LachromElite manufactured by Hitachi High-Technologies Corporation) and analyzed. The columns were two of TSKgel GMHHR-M (length 30 cm × inner diameter 7.8 mm) manufactured by Tosoh Corporation, the mobile phase was tetrahydrofuran, the flow rate was 1 mL/min., and the detector was RI. The weight average molecular weight Mw of the cyanate ester compound was obtained by a GPC method using polystyrene as a standard substance.

(Synthesis Example 1) Synthesis of Cyanate Ester Compound of Phenol-Modified Naphthalene Formaldehyde Resin (Cyanate Ester Compound of Following Formula (1a) (Having Following Formula (22) as Typical Compositions): Hereinafter Also Abbreviated as "NMCN") 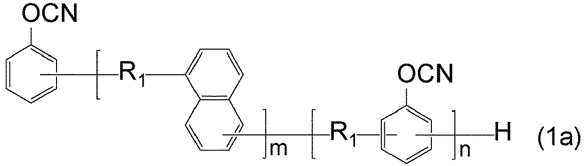 wherein R₁, m, and n have the same meanings as described in the above-described formula (1).

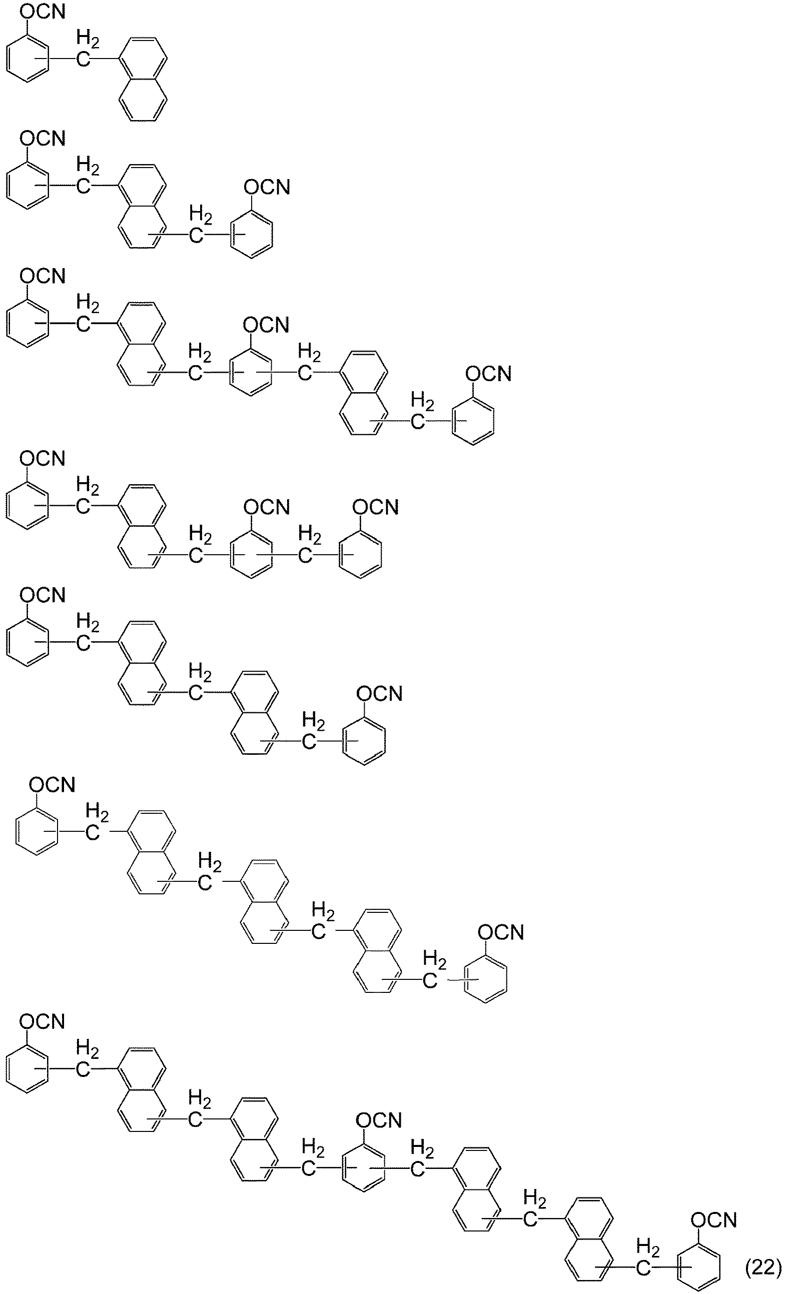

### <Synthesis of Naphthalene Formaldehyde Resin>

681 g of a 37% by mass aqueous solution of formalin (8.4 mol of formaldehyde, manufactured by MITSUBISHI GAS CHEMICAL COMPANY, INC.) and 338 g of 98% by mass sulfuric acid (manufactured by MITSUBISHI GAS CHEMICAL COMPANY, INC.) were stirred under reflux under normal pressure around 100°C. 295 g of molten 1-naphthalenemethanol (1.9 mol, manufactured by TOKYO CHEMICAL INDUSTRY CO., LTD.) was dropped thereinto over 4 hours, and then the mixture was further reacted for 2 hours. 580 g ethylbenzene (manufactured by Wako Pure Chemical Industries, Ltd.) and 460 g of methyl isobutyl ketone (manufactured by Wako Pure Chemical Industries, Ltd.) as diluent solvents were added to the obtained reaction liquid, and the reaction liquid was allowed to stand. Then, the aqueous phase, the lower phase, was removed. Further, the reaction liquid was neutralized and water-washed, and the ethylbenzene and the methyl isobutyl ketone were distilled off under reduced pressure to obtain 332 g of a naphthalene formaldehyde resin, a pale yellow solid.

### <Synthesis of Phenol-Modified Naphthalene Formaldehyde Resin>

305 g of the naphthalene formaldehyde resin obtained above (the number of moles of contained oxygen 2.3 mol) and 536 g of phenol (5.7 mol, manufactured by Wako Pure Chemical Industries, Ltd.) were heated and melted at 100°C, and then 340 mg of para-toluenesulfonic acid (manufactured by Wako Pure Chemical Industries, Ltd.) was added with stirring to start a reaction. While the temperature was raised to 160°C, the mixture was reacted for 2 hours. The obtained reaction liquid was diluted with 1200 g of a mixed solvent (meta-xylene (manufactured by MITSUBISHI GAS CHEMICAL COMPANY, INC.)/methyl isobutyl ketone (manufactured by Wako Pure Chemical Industries, Ltd.) = 1/1 (mass ratio)) and then neutralized and water-washed, and the solvent and the unreacted raw materials were removed under reduced pressure to obtain 550 g of a phenol-modified naphthalene formaldehyde resin, a blackish brown solid, represented by the following formula (10a). The OH value of the obtained phenol-modified naphthalene formaldehyde resin as obtained based on JIS-K1557-1 was 295 mg KOH/g (the OH group equivalent was 190 g/eq.). 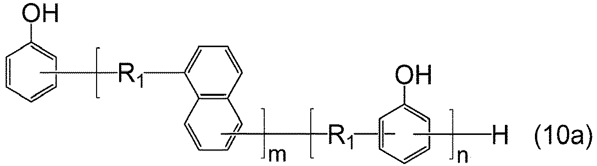 wherein R₁, m, and n have the same meanings as described in the above-described formula (9).

### <Synthesis of NMCN>

550 g of the phenol-modified naphthalene formaldehyde resin represented by formula (10a) obtained by the above method (OH group equivalent 190 g/eq.) (2.90 mol in terms of OH groups) (weight average molecular weight Mw 600) and 439.8 g (4.35 mol) (1.5 mol based on 1 mol of hydroxy groups) of triethylamine were dissolved in 3090 g of dichloromethane, and this solution was a solution 1.

While 285.0 g (4.64 mol) (1.6 mol based on 1 mol of hydroxy groups) of cyanogen chloride, 665.0 g of dichloromethane, 440.2 g (4.35 mol) (1.5 mol based on 1 mol of hydroxy groups) of 36% hydrochloric acid, and 2729.1 g of water were maintained at a liquid temperature of -2 to -0.5°C under stirring, the solution 1 was poured over 55 minutes. After the completion of the pouring of the solution 1, the mixture was stirred at the same temperature for 30 minutes, and then a solution of 263.9 g (2.61 mol) (0.9 mol based on 1 mol of hydroxy groups) of triethylamine dissolved in 264 g of dichloromethane (solution 2) was poured over 30 minutes. After the completion of the pouring of the solution 2, the mixture was stirred at the same temperature for 30 minutes to complete the reaction.

Then, the reaction liquid was allowed to stand to separate the organic phase and the aqueous phase. The obtained organic phase was washed four times with 2000 g of water. The electrical conductivity of the wastewater from the fourth water washing was 20 µS/cm, and it was confirmed that removable ionic compounds were sufficiently removed by the washing with water.

The organic phase after the water washing was concentrated under reduced pressure and finally concentrated to dryness at 90°C for 1 hour to obtain 592 g of the target cyanate ester compound NMCN (light yellow viscous material). The weight average molecular weight Mw of the obtained cyanate ester compound NMCN was 970. In addition, the IR spectrum of the NMCN showed absorption at 2250 cm⁻¹ (cyanate ester groups) and showed no absorption of hydroxy groups.

(Synthesis Example 2) Synthesis of Cyanate Ester Compound of Phenol-Modified Naphthalene Formaldehyde Resin (Cyanate Ester Compound of Following Formula (1b) (Having Following Formula (23) as Typical Compositions): Hereinafter Also Abbreviated as "NRCN") 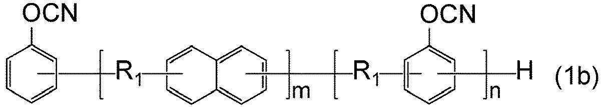 wherein R₁, m, and n have the same meanings as described in the above-described formula (1).

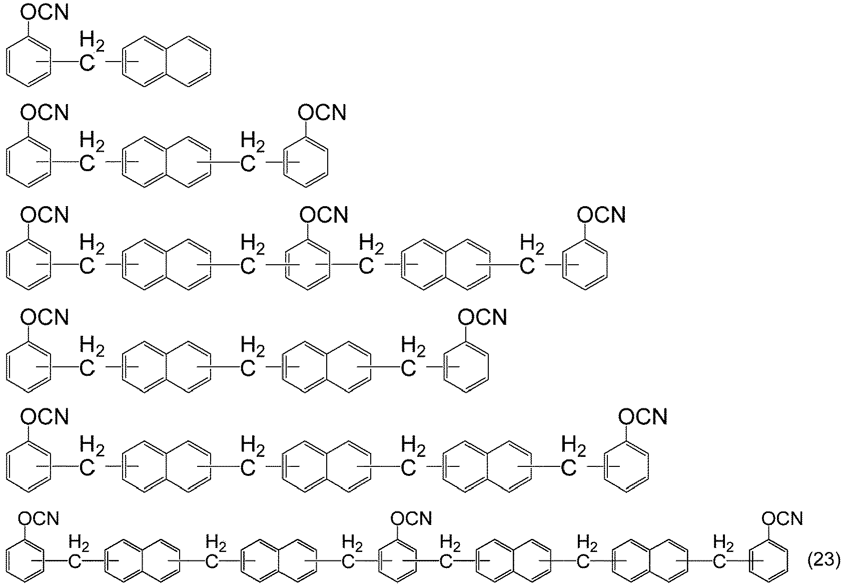

### <Synthesis of Naphthalene Formaldehyde Resin>

3220 g of a 37% by mass aqueous solution of formalin (40 mol of formaldehyde, manufactured by MITSUBISHI GAS CHEMICAL COMPANY, INC.), 142 g of methanol (manufactured by MITSUBISHI GAS CHEMICAL COMPANY, INC.) and 1260 g of 98% by mass sulfuric acid (manufactured by MITSUBISHI GAS CHEMICAL COMPANY, INC.) were stirred under reflux under normal pressure around 100°C. 640 g of molten naphthalene (5.0 mol, manufactured by KANTO CHEMICAL CO., INC.) was dropped thereinto over 6 hours, and then the mixture was further reacted for 2 hours. 630 g ethylbenzene (manufactured by Wako Pure Chemical Industries, Ltd.) and 630 g of methyl isobutyl ketone (manufactured by Wako Pure Chemical Industries, Ltd.) as diluent solvents were added to the obtained reaction liquid, and the reaction liquid was allowed to stand. Then, the aqueous phase, the lower phase, was removed. Further, the reaction liquid was neutralized and water-washed, and the ethylbenzene and the methyl isobutyl ketone were distilled off under reduced pressure to obtain 816 g of a naphthalene formaldehyde resin, a pale yellow solid.

### <Synthesis of Acetal Bond-Removed Naphthalene Formaldehyde Resin>

500 g of the naphthalene formaldehyde resin obtained above was melted at 120°C, and then 10 mg of para-toluenesulfonic acid (manufactured by Wako Pure Chemical Industries, Ltd.) was added under a steam flow with stirring, and the temperature was raised to 190°C in 1 hour. Then, the mixture was further reacted for 4 hours (a total of 5 hours). The obtained reaction liquid was diluted with 500 g of ethylbenzene (manufactured by KANTO CHEMICAL CO., INC.) and then neutralized and water-washed, and the solvent was removed under reduced pressure to obtain 380 g of an acetal bond-removed naphthalene formaldehyde resin, a light-red solid.

### <Synthesis of Phenol-Modified Naphthalene Formaldehyde Resin>

584 g of phenol (6.2 mol, manufactured by Wako Pure Chemical Industries, Ltd.) was heated and melted at 100°C, and then 110 mg of para-toluenesulfonic acid (manufactured by Wako Pure Chemical Industries, Ltd.) was added with stirring to start a reaction. While the temperature of the mixture was raised to 190°C, 380 g of the acetal bond-removed naphthalene formaldehyde resin obtained above (the number of moles of contained oxygen 1.2 mol) was added over 1 hour. Then, the mixture was further reacted for 3 hours. The obtained reaction liquid was diluted with 1000 g of a mixed solvent (meta-xylene (manufactured by MITSUBISHI GAS CHEMICAL COMPANY, INC.)/methyl isobutyl ketone (manufactured by Wako Pure Chemical Industries, Ltd.) = 1/1 (mass ratio)) and then neutralized and water-washed, and the solvent and the unreacted raw materials were removed under reduced pressure to obtain 530 g of a phenol-modified naphthalene formaldehyde resin, a blackish brown solid, represented by the following formula (10b). The OH value of the obtained phenol-modified naphthalene formaldehyde resin as obtained based on JIS-K1557-1 was 193 mg KOH/g (the OH group equivalent was 290 g/eq.). 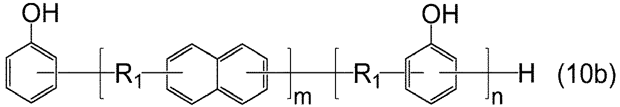 wherein R₁, m, and n have the same meanings as described in the above-described formula (9).

### <Synthesis of NRCN>

526 g of the phenol-modified naphthalene formaldehyde resin represented by formula (10b) obtained by the above method (OH group equivalent 290 g/eq.) (1.81 mol in terms of OH groups) (weight average molecular weight Mw 700) and 275.5 g (2.72 mol) (1.5 mol based on 1 mol of hydroxy groups) of triethylamine were dissolved in 2943 g of dichloromethane, and this solution was a solution 1.

While 178.5 g (2.90 mol) (1.6 mol based on 1 mol of hydroxy groups) of cyanogen chloride, 416.5 g of dichloromethane, 275.7 g (2.72 mol) (1.5 mol based on 1 mol of hydroxy groups) of 36% hydrochloric acid, and 1710 g of water were maintained at a liquid temperature of -2 to -0.5°C under stirring, the solution 1 was poured over 55 minutes. After the completion of the pouring of the solution 1, the mixture was stirred at the same temperature for 30 minutes, and then a solution of 110.2 g (1.09 mol) (0.6 mol based on 1 mol of hydroxy groups) of triethylamine dissolved in 110.2 g of dichloromethane (solution 2) was poured over 13 minutes. After the completion of the pouring of the solution 2, the mixture was stirred at the same temperature for 30 minutes to complete the reaction.

Then, the reaction liquid was allowed to stand to separate the organic phase and the aqueous phase. The obtained organic phase was washed four times with 2000 g of water. The electrical conductivity of the wastewater from the fourth water washing was 15 µS/cm, and it was confirmed that removable ionic compounds were sufficiently removed by the washing with water.

The organic phase after the water washing was concentrated under reduced pressure and finally concentrated to dryness at 90°C for 1 hour to obtain 556 g of the target cyanate ester compound NRCN (light yellow viscous material). The weight average molecular weight Mw of the obtained cyanate ester compound NRCN was 1000. In addition, the IR spectrum of the NRCN showed absorption at 2250 cm⁻¹ (cyanate ester groups) and showed no absorption of hydroxy groups.

### (Example 1)

50 Parts by mass of the NMCN obtained by Synthesis Example 1, 50 parts by mass of a biphenyl aralkyl-based epoxy resin (NC-3000-FH, manufactured by Nippon Kayaku Co., Ltd.), 100 parts by mass of fused silica (SC2050MB, manufactured by Admatechs Company Limited), and 0.05 parts by mass of zinc octylate (manufactured by Nihon Kagaku Sangyo Co., Ltd.) were mixed to obtain a varnish (resin composition). This varnish was diluted with methyl ethyl ketone, and an E-glass woven cloth having a thickness of 0.1 mm was impregnated and coated with the diluted varnish and heated and dried at 150°C for 5 minutes to obtain a prepreg having a resin content of 50% by mass.

Eight of the obtained prepregs were stacked, and 12 µm thick electrolytic copper foil (JDLCN, manufactured by JX NIPPON MINING & METALS CORP.) was disposed on the top and the bottom. The stack was laminate-molded at a pressure of 30 kgf/cm² and a temperature of 220°C for 120 minutes to obtain a metal foil-clad laminate having an insulating layer thickness of 0.8 mm. The evaluation of the water absorption rate, moisture absorption and heat resistance properties, and flame retardancy was performed using the obtained metal foil-clad laminate. The results are shown in Table 1.

### (Measurement Methods and Evaluation Methods)

1) Water absorption rate: The water absorption rate after treatment at 121°C and 2 atmospheres by a pressure cooker tester (manufactured by HIRAYAMA MANUFACTURING CORPORATION, model PC-3) for 1, 3, and 5 hours was measured in accordance with JIS C648 using a 30 mm × 30 mm sample.
2) Moisture absorption and heat resistance properties: A test piece obtained by removing all the copper foil of a 50 mm × 50 mm sample except half of the copper foil on one surface by etching was treated at 121°C and 2 atmospheres by a pressure cooker tester (manufactured by HIRAYAMA MANUFACTURING CORPORATION, model PC-3) for 3, 4, and 5 hours and then immersed in solder at 260°C for 60 seconds. Then, appearance change was visually observed. (the number of occurring blisters/the number of tests)
3) Flame retardancy: All of the copper foil of a 13 mm × 130 mm sample was removed by etching to obtain a test piece. A flame resistance test was carried out in accordance with the UL94 vertical test method using this test piece (n = 5).

### (Example 2)

A metal foil-clad laminate having a thickness of 0.8 mm was obtained as in Example 1 except that in Example 1, 50 parts by mass of the NRCN was used instead of using 50 parts by mass of the NMCN, and heating was performed at 165°C for 5 minutes during impregnation and coating. The evaluation results of the obtained metal foil-clad laminate are shown in Table 1.

### (Comparative Example 1)

A metal foil-clad laminate having a thickness of 0.8 mm was obtained as in Example 1 except that in Example 1, 50 parts by mass of a bisphenol A-based cyanate ester compound (CA210, manufactured by MITSUBISHI GAS CHEMICAL COMPANY, INC.) and 0.03 parts by mass of zinc octylate were used instead of using 50 parts by mass of the NMCN. The evaluation results of the obtained metal foil-clad laminate are shown in Table 1.

### (Comparative Example 2)

A metal foil-clad laminate having a thickness of 0.8 mm was obtained as in Example 1 except that in Example 1, 50 parts by mass of a phenol novolac-based cyanate ester compound (Primaset PT-30, manufactured by Lonza Japan Ltd.) and 0.04 parts by mass of zinc octylate were used instead of using 50 parts by mass of the NMCN, and heating and drying was performed at 165°C for 4 minutes during impregnation and coating. The evaluation results of the obtained metal foil-clad laminate are shown in Table 1.

**[Table 1]**

| | | Example 1 | Example 2 | Comparative Example 1 | Comparative Example 2 |
|---|---|---|---|---|---|
| Water absorption rate (%) | After treatment for 1 hour | 0.13 | 0.12 | 0.21 | 0.28 |
| | After treatment for 3 hours | 0.24 | 0.22 | 0.35 | 0.44 |
| | After treatment for 5 hours | 0.28 | 0.26 | 0.38 | 0.52 |
| Moisture absorption and heat resistance properties | After treatment for 3 hours | 0/4 | 0/4 | 2/4 | 1/4 |
| | After treatment for 4 hours | 1/4 | 1/4 | 1/4 | 1/4 |
| | After treatment for 5 hours | 1/4 | 0/4 | 3/4 | 1/4 |
| Flame retardancy | | V-0 | V-1 | V-1 | V-1 |

As is clear from Table 1, it was confirmed that by using the resin compositions in these Examples, prepregs, printed wiring boards, and the like that not only had low water absorbency but also had excellent moisture absorption and heat resistance properties and flame retardancy were realized.

### Industrial Applicability

As described above, the resin composition of the present invention can be widely and effectively used in various applications such as electrical and electronic materials, machine tool materials, and aviation materials, for example, as electrical insulating materials, semiconductor plastic packages, sealing materials, adhesives, lamination materials, resists, and buildup laminate materials and, particularly, can be especially effectively used as printed wiring board materials adapted to higher integration and higher density for information terminal equipment, communication equipment, and the like in recent years. In addition, the laminate, metal foil-clad laminate, and the like of the present invention not only have low water absorbency but have performance also excellent in moisture absorption and heat resistance properties and flame retardancy, and therefore their industrial practicality is extremely high.

## Claims

1. A resin composition comprising:
a cyanate ester compound (A) obtained by cyanating a modified naphthalene formaldehyde resin; and
an epoxy resin (B),
wherein the cyanate ester compound (A) has a structure represented by the following general formula (1) : 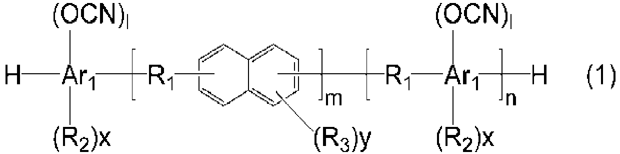
wherein Ar₁ represents an aromatic ring, R₁ each independently represents a methylene group, a methyleneoxy group, a methyleneoxymethylene group, an oxymethylene group, or a combination thereof, resulting from linking the same; R₂ represents a monovalent substituent and each independently represents a hydrogen atom, an alkyl group, or an aryl group, R₃ each independently represents a hydrogen atom, an alkyl group having 1 to 3 carbon atoms, an aryl group, a hydroxy group, or a hydroxymethylene group, m represents an integer of 1 or more, and n represents an integer of 0 or more; the cyanate ester compound may be a mixture of compounds having different m and n; 1 represents a number of bonded cyanato groups and is each independently an integer of 1 to 3; x represents a number of bonded R₂ and is "a number of possible bonds of Ar₁ - (1 + 2);" and y each independently represents an integer of 0 to 4.

2. The resin composition according to claim 1, wherein a content of the cyanate ester compound (A) obtained by cyanating the modified naphthalene formaldehyde resin is 1 to 90 parts by mass when a content of a resin solid in the resin composition is 100 parts by mass.

3. The resin composition according to claim 1 or 2, further comprising an inorganic filler (C).

4. The resin composition according to any one of claims 1 to 3, further comprising one or more selected from the group consisting of a maleimide compound, a phenolic resin, and a cyanate ester compound other than the cyanate ester compound (A) obtained by cyanating the modified naphthalene formaldehyde resin.

5. The resin composition according to any one of claims 1 to 4, wherein the epoxy resin (B) is one or more selected from the group consisting of a biphenyl aralkyl-based epoxy resin, a naphthylene ether-based epoxy resin, a polyfunctional phenol-based epoxy resin, and a naphthalene-based epoxy resin.

6. The resin composition according to claim 3, wherein a content of the inorganic filler (C) is 50 to 1600 parts by mass when a content of a resin solid in the resin composition is 100 parts by mass.

7. A prepreg obtained by impregnating or coating a base material with the resin composition according to any one of claims 1 to 6.

8. A metal foil-clad laminate obtained by stacking at least one or more of the prepregs according to claim 7, disposing metal foil on one surface or both surfaces of an obtained stack, and laminate-molding the metal foil and the stack.

9. A resin composite sheet obtained by coating a surface of a support with the resin composition according to any one of claims 1 to 6 and drying the resin composition.

10. A printed wiring board comprising an insulating layer and a conductor layer formed on a surface of the insulating layer, wherein the insulating layer comprises the resin composition according to any one of claims 1 to 6.

## Patentansprüche

1. Harzzusammensetzung, umfassend:
eine Cyanatesterverbindung (A), die durch Cyanierung eines modifizierten Naphthalinformaldehydharzes erhalten wird, und
ein Epoxidharz (B),
wobei die Cyanatesterverbindung (A) eine durch die folgende allgemeine Formel (1) dargestellte Struktur aufweist: 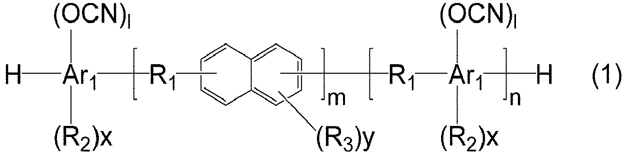
worin Ar₁ einen aromatischen Ring darstellt, R₁ jeweils unabhängig eine Methylengruppe, eine Methylenoxygruppe, eine Methylenoxymethylengruppe, Oxymethylengruppe oder eine Kombination davon, die aus der Verknüpfung derselben resultiert, darstellt, R₂ einen monovalenten Substituenten darstellt und jeweils unabhängig ein Wasserstoffatom, eine Alkylgruppe oder eine Arylgruppe darstellt, R₃ jeweils unabhängig ein Wasserstoffatom, eine Alkylgruppe mit 1 bis 3 Kohlenstoffatomen, eine Arylgruppe, eine Hydroxygruppe oder eine Hydroxymethylengruppe darstellt, m eine ganze Zahl von 1 oder größer darstellt und n eine ganze Zahl von 0 oder größer darstellt, die Cyanatesterverbindung eine Mischung aus Verbindungen mit unterschiedlichem m und n sein kann, 1 eine Anzahl von gebundenen Cyanatogruppen darstellt und jeweils unabhängig eine ganze Zahl von 1 bis 3 ist, x eine Anzahl von gebundenen R₂ darstellt und "eine Anzahl von möglichen Bindungen Ar₁ - (1 + 2)" ist und y jeweils unabhängig eine ganze Zahl von 0 bis 4 darstellt.

2. Harzzusammensetzung gemäß Anspruch 1, wobei ein Gehalt der Cyanatesterverbindung (A), die durch Cyanierung des modifizierten Naphthalinformaldehydharzes erhalten wird, 1 bis 90 Masse-% beträgt, wenn ein Gehalt eines Harzfeststoffs in der Harzzusammensetzung 100 Masse-% beträgt.

3. Harzzusammensetzung gemäß Anspruch 1 oder 2, ferner umfassend einen anorganischen Füllstoff (C).

4. Harzzusammensetzung gemäß irgendeinem der Ansprüche 1 bis 3, ferner umfassend eines/eine oder mehrere, ausgewählt aus der Gruppe, bestehend aus einer Maleimidverbindung, einem Phenolharz und einer Cyanatesterverbindung außer der Cyanatesterverbindung (A), die durch Cyanierung des modifizierten Naphthalinformaldehydharzes erhalten wird.

5. Harzzusammensetzung gemäß irgendeinem der Ansprüche 1 bis 4, wobei das Epoxidharz (B) eines oder mehrere, ausgewählt aus der Gruppe, bestehend aus einem Epoxidharz auf Basis eines Biphenylaralkyls, einem Epoxidharz auf Basis eines Naphthalinethers, einem Epoxidharz auf Basis eines polyfunktionellen Phenols und einem Epoxidharz auf Naphthalinbasis, ist.

6. Harzzusammensetzung gemäß Anspruch 3, wobei ein Gehalt des anorganischen Füllstoffs (C) 50 bis 1.600 Masseteile beträgt, wenn ein Gehalt eines Harzfeststoffs in der Harzzusammensetzung 100 Masseteile beträgt.

7. Prepreg, erhalten durch Imprägnieren oder Beschichten eines Basismaterials mit der Harzzusammensetzung gemäß irgendeinem der Ansprüche 1 bis 6.

8. Metallfolien-kaschiertes Laminat, erhalten durch Stapeln von mindestens einem oder mehreren der Prepregs gemäß Anspruch 7, Anordnen einer Metallfolie auf einer Oberfläche oder beiden Oberflächen eines erhaltenen Stapels und Laminatformen der Metallfolie und des Stapels.

9. Harzverbundfolie, erhalten durch Beschichten einer Oberfläche eines Trägers mit der Harzzusammensetzung gemäß irgendeinem der Ansprüche 1 bis 6 und Trocknen der Harzzusammensetzung.

10. Gedruckte Verdrahtungsplatte, umfassend eine Isolierschicht und eine Leiterschicht, die auf einer Oberfläche der Isolierschicht gebildet ist, wobei die Isolierschicht die Harzzusammensetzung gemäß irgendeinem der Ansprüche 1 bis 6 umfasst.

## Revendications

1. Composition de résine comprenant :
un composé ester de cyanate (A) obtenu par cyanation d'une résine de naphtalène-formaldéhyde modifiée ; et
une résine époxy (B),
dans laquelle le composé ester de cyanate (A) possède une structure représentée par la formule générale (1) suivante : 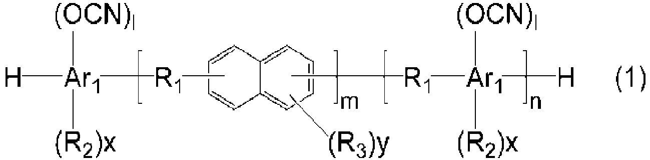
dans laquelle Ar₁ représente un cycle aromatique, R₁ représente chaque fois indépendamment un groupe méthylène, un groupe méthylèneoxy, un groupe méthylèneoxyméthylène, un groupe oxyméthylène ou une combinaison de ceux-ci, résultant de leur liaison ; R₂ représente un substituant monovalent et représente chaque fois indépendamment un atome d'hydrogène, un groupe alkyle ou un groupe aryle, R₃ représente chaque fois indépendamment un atome d'hydrogène, un groupe alkyle possédant 1 à 3 atomes de carbone, un groupe aryle, un groupe hydroxy ou un groupe hydroxyméthylène, m représente un entier valant 1 ou plus et n représente un entier valant 0 ou plus; le composé ester de cyanate peut être un mélange de composés possédant différents m et n ; l représente un nombre de groupes cyanato liés et est chaque fois indépendamment un entier valant 1 à 3; x représente un nombre de R₂ liés et est « un nombre de liaisons possibles de Ar₁ - (1 + 2) ; » et y représente chaque fois indépendamment un entier valant 0 à 4.

2. Composition de résine selon la revendication 1, dans laquelle une teneur du composé ester de cyanate (A) obtenu par cyanation de la résine de naphtalène-formaldéhyde modifiée est de 1 à 90 parties en masse lorsqu'une teneur d'une résine solide dans la composition de résine est de 100 parties en masse.

3. Composition de résine selon la revendication 1 ou 2, comprenant en outre une charge inorganique (C).

4. Composition de résine selon l'une quelconque des revendications 1 à 3, comprenant en outre un ou plusieurs sélectionnés dans le groupe constitué par un composé maléimide, une résine phénolique et un composé ester de cyanate autre que le composé ester de cyanate (A) obtenu par cyanation de la résine de naphtalène-formaldéhyde modifiée.

5. Composition de résine selon l'une quelconque des revendications 1 à 4, dans laquelle la résine époxy (B) est une ou plusieurs sélectionnées dans le groupe constitué par une résine époxy à base de biphénylaralkyle, une résine époxy à base d'éther de naphtylène, une résine époxy à base de phénol polyfonctionnel et une résine époxy à base de naphtalène.

6. Composition de résine selon la revendication 3, dans laquelle une teneur de la charge inorganique (C) est de 50 à 1 600 parties en masse lorsqu'une teneur d'une résine solide dans la composition de résine est de 100 parties en masse.

7. Préimprégné obtenu en imprégnant ou en revêtant un matériau de base avec la composition de résine selon l'une quelconque des revendications 1 à 6.

8. Stratifié recouvert d'une feuille de métal obtenu en empilant au moins un ou plusieurs des préimprégnés selon la revendication 7, en disposant une feuille de métal sur une surface ou les deux surfaces d'une pile obtenue et en moulant par stratification la feuille de métal et la pile.

9. Feuille composite de résine obtenue en revêtant une surface sur un support avec la composition de résine selon l'une quelconque des revendications 1 à 6 et en séchant la composition de résine.

10. Carte de circuit imprimé comprenant une couche isolante et une couche conductrice formée sur une surface de la couche isolante, dans laquelle la couche isolante comprend la composition de résine selon l'une quelconque des revendications 1 à 6.
